(19) Europäisches Patentamt

European Patent Office

Office européen des brevets

(11) **EP 0 435 058 B1**

(12) **EUROPÄISCHE PATENTSCHRIFT**

(45) Veröffentlichungstag und Bekanntmachung des Hinweises auf die Patenterteilung:
**08.03.2000 Patentblatt 2000/10**

(51) Int. Cl.⁷: **G03F 3/10**, B32B 31/00, B41F 5/20

(21) Anmeldenummer: **90123764.4**

(22) Anmeldetag: **11.12.1990**

(54) **Schichtübertragungsverfahren zur Bilderzeugung**

Layer transfer process for image production

Procédé de transfert des couches pour la production d'images

(84) Benannte Vertragsstaaten:
**BE DE FR GB IT NL**

(30) Priorität: **23.12.1989 DE 3942816**

(43) Veröffentlichungstag der Anmeldung:
**03.07.1991 Patentblatt 1991/27**

(73) Patentinhaber:
**E.I. DU PONT DE NEMOURS AND COMPANY
Wilmington Delaware 19898 (US)**

(72) Erfinder: **Sandner, Helmut
W-6054 Rodgau 3 (DE)**

(74) Vertreter: **Kuhnen & Wacker
Patentanwaltsgesellschaft mbH,
Alois-Steinecker-Strasse 22
85354 Freising (DE)**

(56) Entgegenhaltungen:
**EP-A- 0 261 246     EP-A- 0 340 603
DE-A- 3 800 768     DE-B- 1 111 003
US-A- 3 754 920     US-A- 3 775 113
US-A- 3 904 411     US-A- 4 069 081
US-A- 4 603 569**

• **PATENT ABSTRACTS OF JAPAN vol. 10, no. 44
(M-455)(2101) 21. Februar 1986 & JP-A-60 196
206 (ISHIKAWAJIMA HARIMA JUKOGYO K.K. )**

**Beschreibung**

Die Erfindung betrifft ein Schichtübertragungsverfahren zur Bilderzeugung, bei dem vorbestimmte Bereiche der Oberfläche eines Bildträgers zur Aufnahme einer Farbschicht vorbereitet werden, der Bildträger und ein Farbträger aus Schichtübertragungsmaterial unter Druck miteinander in Kontakt gebracht werden und der Farbträger vom Bildträger entfernt wird, wobei Farbe auf den vorbestimmten Bereichen des Bildträgers verbleibt.

Schichtübertragungsmaterialien und -verfahren sind bekannt und haben eine vielfache Anwendung in der elektronischen Industrie, z.B. für die Herstellung von Fotoresistmasken und Lötstopmasken, und in der Druckindustrie, z.B. zur Herstellung von Farbreproduktionen und zur Prüfung von Farbauszügen, gefunden. In Farbprüfverfahren werden sowohl lichtempfindliche Schichtübertragungsmaterialien (z.B. die der US 4,356,253 und der EP 02 43 933 A) zur Bildträgerherstellung verwendet als auch nicht lichtempfindliche Schichtübertragungsmaterialien als Farbträger wie sie z.B. in DE 36 25 014 C oder in DE 37 06 528 A offenbart sind.

Zur Vorbereitung des Farbauftrags auf den Bildträger wird die Oberfläche des Bildträgers in geeigneter Weise belichtet, beispielsweise mit einer Lichtquelle, die ihr Licht durch ein Negativ oder ein Positiv auf den Bildträger sendet, oder durch einen gesteuerten Laserstrahl. Die belichteten und unbelichteten Bereiche unterscheiden sich dann in ihrer Fähigkeit, Farbe von einem Farbträger, der mit dem Bildträger in Kontakt gebracht und danach wieder von diesem entfernt wird, aufzunehmen. Insbesondere beim Prüfen von Farbauszügen in der Druckindustrie ist es erforderlich, daß die Farbübertragung mit der gleichen Qualität erfolgt wie beim Drucken. Beim Farbdruck, der in der Regel mit vier Farben erfolgt, wird jede Farbe nicht flächig, sondern in Form von kleinen Punkten aufgetragen. Die dazu notwendige Vorlage wird zu diesem Zweck gerastert, wobei die Farbpunkte auf dem Bildträger in einem regelmäßigen Raster erscheinen sollen. Die Intensität der einzelnen Farben wird durch die Größe der Farbpunkte bestimmt. Nach allgemeinen Standardvorschriften wird z.B. für einen hochwertigen Offsetdruck eine Auflösung von 2% bis 98% Punkten bei einer Rasterweite von 60 Linien/cm gefordert, wobei es besonders schwierig ist, eine befriedigende Auflösung der spitzen 2% Punkte in den Lichtern und der 98% Punkte in der Volldeckung zu erreichen. 2% Punkte haben dabei einen Durchmesser von ca. 27 µm. Für eine gute Tonwertwiedergabe ist es ferner von erheblicher Bedeutung, daß Rasterpunkte gleicher Größe über den gesamten Flächenbereich scharf begrenzt und gleichmäßig, d.h. ohne Schwankungen in der Größe wiedergegeben werden. Um eine zufriedenstellende Qualität der Bildwiedergabe zu erreichen, muß sichergestellt sein, daß die Farbe überall dort auf dem Bildträger haften bleibt, wo Farbe vorgesehen ist. Dies ist insbesondere bei kleinen Farbpunkten schwierig. Wenn aber gerade kleine Farbpunkte fehlen, führt dies zu Fehl-stellen auf dem Bildträger, die die tonwertrichtige Wiedergabe der Vorlage verfälschen.

Der Erfindung liegt daher die Aufgabe zugrunde, ein Schichtübertragungsverfahren zur Bilderzeugung anzugeben, mit dem eine hohe Gleichmäßigkeit der Rastertonwerte über die gesamte Fläche erzielt werden kann.

Diese Aufgabe wird bei einem Schichtübertragungsverfahren der eingangs genannten Art erfindungsgemäß dadurch gelöst, daß der Kontakt unter so hohem Druck erfolgt, daß Bildträger und/oder Farbträger an ihren einander zugewandten Oberflächen zumindest temporär eingedrückt werden, wobei die Summe der Eindrücktiefen mindestens der Summe der lokalen Rauhtiefen entspricht.

Obwohl sich die Oberfläche von Bildträger und Farbträger relativ glatt anfühlen, zeigt eine nähere Betrachtung der Oberflächen, daß die Oberflächenrauhigkeit relativ groß im Verhältnis zu der zu übertragenden Farbschicht ist. Bei einer mikroskopischen Vergrößerung stellen sich die Oberflächen von Bildträger und Farbträger als Gebirge dar, wobei die Unterschiede zwischen Gipfeln und Tälern eine Größenordnung von ca. 10 bis 15 µm erreichen können. Bei der Farbübertragung kann es nun vorkommen, daß sich zwei "Täler" von Bildträger und Farbträger gegenüber stehen. Die Farbe im Tal des Farbträgers wird daher nur mit geringem Druck oder sogar ohne Druck mit dem Bildträger in Kontakt gebracht. Im Extremfall erfolgt überhaupt kein Kontakt an dieser Stelle. Dies kann dazu führen, daß beim Abziehen des Farbträgers die Farbe nur unzureichend oder gar nicht am Bildträger haftet und eine Fehlstelle erzeugt. Erfindungsgemäß wird das Problem dadurch umgangen, daß Farbträger und Bildträger mit einem so hohen Druck aufeinander gepreßt werden, daß sich ihre Oberflächenstrukturen einander anpassen. Je nach Härte der verwendeten Materialien werden beispielsweise hervorstehende Gipfel des Farbträgers in die Oberfläche des Bildträgers eingedrückt und zwar so lange, bis ein Zustand erreicht ist, bei dem sich die Oberflächen von Farbträger und Bildträger vollständig berühren. Natürlich kann es vorkommen, daß sich der Bildträger in dem Bereich, wo seine Oberfläche eingedrückt ist, aufgrund des Drucks verhärtet, so daß er dann härter wird, als der Farbträger. Bei einer Zunahme des Drucks wird dann auch der Farbträger eingedrückt, so daß schließlich in jedem Fall die beiden Oberflächen von Bildträger und Farbträger vollständig aneinander liegen, d.h. sich praktisch in jedem Punkt berühren. Dadurch wird erreicht, daß die Farbe des Farbträgers mit einer größeren Gleichmäßigkeit auf den Bildträger gepreßt wird. Infolgedessen ist der Farbauftrag auf den Bildträger gleichmäßiger. Die lokale Rauhtiefe ist dabei ein Maß für den Höhenunterschied zwischen benachbarten "Gipfeln" und "Tälern" auf der Oberfläche von Bildträger bzw. Farbträger.

Die Durchführung eines Schichtübertragungsverfahrens zur Bilderzeugung mit einem derartig hohen Druck wurde bisher für unmöglich gehalten. Man befürchtete, daß ein derartig hoher Druck die Registrierung verfälschen würde. Dies würde ein mehrfaches Durchführen des Verfahrens, beispielsweise zur Erzeugung von Vierfarb-Abzügen, unmöglich machen, da man nicht mehr gewährleisten könnte, daß die einzelnen Farben exakt positioniert werden können. Ferner befürchtete man, daß durch einen derartig hohen Druck ein Punktzuwachs auftreten würde, wodurch die Wiedergabe der Vorlage ebenfalls verfälscht würde. Es hat sich nun aber herausgestellt, daß diese Befürchtungen nicht zutreffen.

Mit Vorteil wird der Bildträger an der dem Farbträger zugewandten Oberfläche mindestens um die Summe der Rauhtiefen von Farbträger und Bildträger eingedrückt. Dabei gibt es die wenigsten Probleme mit einer genauen Ausrichtung des Bildträgers. Die Kraft, die zur Erzeugung des Druckes notwendig ist, kann niedriger gewählt werden, da der Farbträger der Druckaufbringung in der Regel weniger Widerstand entgegensetzt als der Bildträger. Der Druck kann also durch den Farbträger hindurch leichter auf die Oberfläche des Bildträgers wirken als durch den Bildträger selbst hindurch.

In einer weiteren Ausgestaltung des Verfahrens wird bei einem eine Unterlage aufweisenden Bildträger die Größe des Drucks so begrenzt, daß die Unterlage nur elastisch verformt wird. Damit wird gewährleistet, daß die Registrierung auf jeden Fall erhalten bleibt. Eine Verschiebung der Bereiche, die für die Farbaufnahme vorbereitet worden sind, relativ zueinander, findet, wenn überhaupt, nur temporär statt, so daß auf den gleichen Bildträger ein weiterer Farbabzug aufgebracht werden kann.

In einer bevorzugten Ausführungsform wird der Druck in einem kontinuierlich über Farb- und Bildträger parallel verschobenen, im Vergleich zur Länge schmalen Streifen erzeugt. Wenn der Druck auf einer kleinen Fläche erzeugt wird, ist dafür nur eine vergleichsweise geringe Kraft notwendig. Um eine gute Farbübertragung vom Farbträger auf den Bildträger zu erreichen, reicht eine kurzzeitige Druckaufbringung aus.

Mit Vorteil werden Bildträger und Farbträger unbeheizt miteinander in Kontakt gebracht. Die Verarbeitung kann also bei Raumtemperatur erfolgen. Bei bekannten Verfahren wurden Bildträger und/oder Farbträger in der Regel beheizt, sei es durch eine vorgeschaltete Heizung oder durch beheizte Walzen beim Aufbringen des Drucks. Damit sollte versucht werden, die Eigenschaften von Farbträger und Bildträger günstig zu beeinflussen, um einen fehlerfreien Farbauftrag zu erreichen. Nach der bevorzugten Ausführungsform ist dies nicht notwendig, da der Farbauftrag bereits durch die Verminderung der Oberflächenrauhigkeit vergleichmäßigt werden kann.

In einer besonders bevorzugten Ausführungsform werden Bildträger und Farbträger erst unmittelbar vor Aufbau des Drucks miteinander in Kontakt gebracht. Die Gefahr, daß sich Farbe vom Farbträger durch ungewollten Kontakt oder Reibung zwischen Farbträger und Bildträger auf den Bildträger überträgt, wird dadurch weitgehend vermindert. Dadurch wird ausgeschlossen, daß Farbe bereits von den Bereichen des Farbträgers entfernt worden ist, die später auf den Bildträger übertragen werden sollte, wenn dieser Bereich des Farbträgers mit einem Bereich des Bildträgers in Kontakt gebracht wird, der zur Aufnahme von Farbe vorbereitet worden ist.

Vorteilhafterweise wird auf die Unterlage des Bildträgers zur Vorbereitung der Oberfläche eine fotobeeinflußbare Schicht aufgebracht und der Bildträger daraufhin durch eine Bilderzeugungseinrichtung belichtet. Als Bilderzeugungseinrichtung kann, wie erwähnt, eine Lichtquelle dienen, die ihre Strahlen durch ein Negativ bzw. ein Positiv (je nach Eigenschaften der fotobeeinflußbaren Schicht) sendet. Die durch die geschwärzten Teile des Negativs bzw. des Positivs nicht abgedeckten Teile des Bildträgers, d.h. die belichteten Teile, ändern ihre Oberflächeneigenschaften, beispielsweise verlieren sie die Fähigkeit, Farbe vom Farbträger anhaften zu lassen.

Mit Vorteil wird die fotobeeinflußbare Schicht auflaminiert. Dieses Verfahren hat sich zur Aufbringung der fotobeeinflußbaren Schicht bewährt.

Mit Vorteil wird die Oberfläche des Bildträgers durch die Belichtung in den belichteten bzw. nach dem Verfahren der DE 26 23 850 C3 in den unbelichteten Bereichen in ihrer Klebrigkeit verändert. Die Farbe kann dann an den klebrig gebliebenen Bereichen haften bleiben, während sie von den nicht mehr klebrigen Bereichen abgezogen werden kann.

Dabei ist bevorzugt, daß die Oberfläche durch die Belichtung in den belichteten Bereichen fotopolymerisiert wird.

Eine Vorrichtung zur Durchführung des Verfahrens ist dadurch gekennzeichnet, daß der Walzenspalt durch zwei harte Walzen gebildet ist. Durch die beiden harten Walzen läßt sich im Walzenspalt ein wesentlich höherer Druck erzielen als dies bei Walzenspalten mit einer harten und einer weichen Walze bisher möglich war.

Dabei ist bevorzugt, daß die beiden Walzen verschiedene Durchmesser aufweisen. Durch die Kombination von zwei Walzen mit unterschiedlichen Durchmessern läßt sich im Walzenspalt eine weitere Druckerhöhung erreichen. Je kleiner der Durchmesser der Walzen ist, desto größer ist die erzeugte Eindrucktiefe. Andererseits besteht bei einem kleinen Walzendurchmesser die Gefahr, daß sich die Walze verbiegt und nicht mehr überall im Walzenspalt der gleich Druck gezeugt werden kann. Aus diesem Grunde wird eine kleinere Walze mit einer größeren Walze kombiniert, die die mechanische Stabilität wieder erhöht.

Es ist auch von Vorteil, daß die beiden Walzen in Bezug auf die Einlaufrichtung des Bildträgers zueinander versetzt angeordnet sind. Es hat sich herausgestellt, daß mit einer derartigen Anordnung die Gefahr einer Faltenbildung erheblich vermindert wird. Durch den Versatz der beiden Walzen in Bezug auf die Einlaufrichtung des Bildträgers läßt sich bei gleicher äußerer Kraft ferner ein etwas höherer Druck im Walzenspalt erzeugen. Es ergibt sich eine Art Keilwirkung.

Mit Vorteil weist die mit dem Farbträger in Berührung stehende Walze einen kleineren Durchmesser als die mit dem Bildträger in Berührung stehende Walze auf. Der Farbträger weist in der Regel eine geringere Steifigkeit auf als der Bildträger. Der Druck, der auf die Berührungsfläche zwischen Farbträger und Bildträger wirkt, wird daher nicht oder nur in geringerem Ausmaß durch die Steifigkeit des Farbträgers auf eine größere Fläche verteilt. Der hohe Druck kann also unmittelbar auf den Farbträger wirken und den Farbträger in die Oberfläche des Bildträgers eindrücken, wodurch sich die Farbe innig und gleichmäßig mit den vorbestimmten Bereichen des Bildträgers verbindet.

Mit Vorteil ist der Umschlingungswinkel des Farbträgers um die ihm zugeordnete Walze größer als der Umschlingungswinkel des Bildträgers um die gleiche Walze. Unter Umschlingungswinkel ist jeweils der Bereich des Umfangs der Walze zu verstehen, an dem der Farbträger bzw. der Bildträger direkt oder indirekt auf der Walze aufliegen. Dadurch wird erreicht, daß der Farbträger und Bildträger praktisch erst unmittelbar vor dem Einlaufen in den Walzenspalt miteinander in Kontakt kommen.

In einer bevorzugten Ausführungsform sind beide Walzen über ihre Länge senkrecht zur Einlaufrichtung durch je eine Abstützeinrichtung abgestützt, wobei mindestens eine Abstützeinrichtung insbesondere pneumatisch mit Druck beaufschlagbar ist. Ab einem bestimmten Längen/Durchmesser-Verhältnis der Walzen wird durch die Durchbiegung der Walzen der Walzenspalt in einer nicht mehr tolerierbaren Art und Weise verformt. Er ist in der Mitte größer als an den beiden Enden. Dies kann dazu führen, daß die Druckverteilung im Walzenspalt in der Mitte ein Minimum hat. Auch wenn dieses Minimum noch ausreichen würde, um die Oberflächenrauhigkeit zu vermindern, besteht doch die Gefahr, daß durch den erhöhten Druck an den Walzenspaltenden der Farbträger und der Bildträger in die Mitte des Walzenspaltes gefördert werden und es dort zu einer Faltenbildung kommt. Durch die Abstützeinrichtung läßt sich erreichen, daß über die gesamte Breite des Walzenspalts ein gleichmäßiger Druck in dem Spalt zwischen den beiden Walzen aufrechterhalten wird. Der Druck kann dort sehr hohe Werte annehmen, ohne daß die Gefahr besteht, daß es bei dem durchlaufenden Gut (Farbträger und Bildträger) zu einer Faltenbildung kommt.

Mit Vorteil weist jede Abstützeinrichtung Lagerelemente auf, die an der Oberfläche der zugeordneten Walze angreifen. Die Abstützung von außen ist die einfachste Form. Sie läßt sich leicht anbringen. Weiterhin steht ausreichend Platz für eine Druckerzeugungseinrichtung zur Verfügung.

Bevorzugterweise sind die Lagerelemente als Wälzlager, insbesondere als Kugellager ausgebildet, deren Außenringe, gegebenenfalls unter Zwischenlage eines Zwischenrings, auf der Walzenoberfläche abrollen. Durch das Abrollen vermeidet man Schleifspuren auf der Walzenoberfläche, die ebenfalls zu einer Verungleichmäßigung des Drucks im Walzenspalt führen könnten.

Mit Vorteil nimmt jede Abstützeinrichtung auch Kräfte parallel zur Einlaufrichtung auf. Da die beiden Walzen in Bezug auf die Einlaufrichtung zueinander versetzt angeordnet sind, treten bei einer Druckbeaufschlagung senkrecht zur Einlaufrichtung auch Kräfte parallel zur Einlaufrichtung auf. Damit die Abstützeinrichtung ihre Aufgabe auch hier noch zuverlässig erfüllen und eine Aufweitung des Spalts in der Mitte vermeiden kann, nimmt sie auch diese Kräfte auf.

Bevorzugt ist auch, daß die Abstützeinrichtungen auf den Walzen selbstzentrierend ausgebildet sind. Die Walzen werden dann automatisch in der gewünschten Lage gehalten.

Mit Vorteil greifen die Lagerelemente auf beiden Seiten einer senkrecht zur Einlaufrichtung durch die Walzenachse verlaufenden Ebene an der Walzenoberfläche an. Die Lagerelemente können also symmetrisch aufgebaut sein. Dies vereinfacht die Montage und die Vorratshaltung.

Die Erfindung wird im folgenden anhand eines bevorzugten Ausführungsbeispiels in Verbindung mit der Zeichnung beschrieben. Darin zeigen:

Fig. 1      eine schematische Ansicht des Verfahrens,

Fig. 2      eine Querschnittsansicht durch einen Farbträger und einen Bildträger,

Fig. 3      eine schematische Seitenansicht einer Vorrichtung,

Fig. 4      eine Vorderansicht der Vorrichtung,

Fig. 5      eine schematische Darstellung zur Ermittlung der Eindrucktiefe und

Fig. 6      ein Punktraster.

Zur Bilderzeugung wird ein Bildträger 21, der eine mit einer fotoempfindlichen Schicht 2 versehene Unterlage 1 aufweist, von einer Lichtquelle 3 durch ein Negativ 4 einer Vorlage belichtet. Das Negativ 4 weist dunkle Bereiche 5, 6 auf, unter denen kein Licht von der Lichtquelle 3 zur fotoempfindlichen Schicht 2 gelangen kann. Die fotoempfindliche Schicht 2 ist im wesentlichen aus einem fotopolymerisierbaren Material aufgebaut, das zumindest an der Oberfläche klebrig ist. Die Klebrigkeit ist dabei ausreichend, um Farbe anhaften zu lassen. Durch die Belichtung wird das Material polymerisiert, wodurch es, allerdings nur in den belichteten Bereichen, seine Klebrigkeit verliert. Infolge der dunklen Bereiche 5, 6 des Negativs 4, die die fotoempfindliche Schicht 2 während der Belichtung abgedeckt haben, entstehen nach der Fotopolymerisation unbelichtete Bereiche 7, 8 in der Schicht 2, die ihre Klebrigkeit behalten haben. Als nächster Schritt wird ein Farbträger 22, der im wesentlichen aus einer Unterlage 9 und einer an deren Unterseite angebrachten Farbschicht 10 besteht, mit der Schicht 2 des Bildträgers 21 in Berührung gebracht. Zu diesem Zweck werden Farbträger 22 und Bildträger 21 gemeinsam durch einen durch zwei Walzen 11, 12 gebildeten Walzenspalt geführt, wobei beide Walzen durch Kräfte 13, 14 beaufschlagt sind. An den unbelichteten und damit klebrig gebliebenen Bereichen 7, 8 der Schicht 2 haftet die Farbe aus der Farbschicht 10 des Farbträgers 22. Beim Abziehen des Farbträgers 22 vom Bildträger 21 ist die Haftung der Farbe an den klebrigen Bereichen 7, 8 des Bildträgers größer als am Farbträger 22, so daß auf den klebrigen Bereichen 7, 8 Farbflecken 15, 16 verbleiben. Nach dem Abziehen des Farbträgers 22 vom Bildträger 21 ist ein Bild hergestellt, das einem Positiv-Abzug der Vorlage entspricht. Bevorzugterweise werden für dieses Verfahren die in US 4,356,253 und EP 02 43 933 A beschriebenen Materialien für die Herstellung des Bildträgers und die in DE 36 25 014 C oder in DE 37 06 528 A offenbarten Materialien für den Farbträger verwendet.

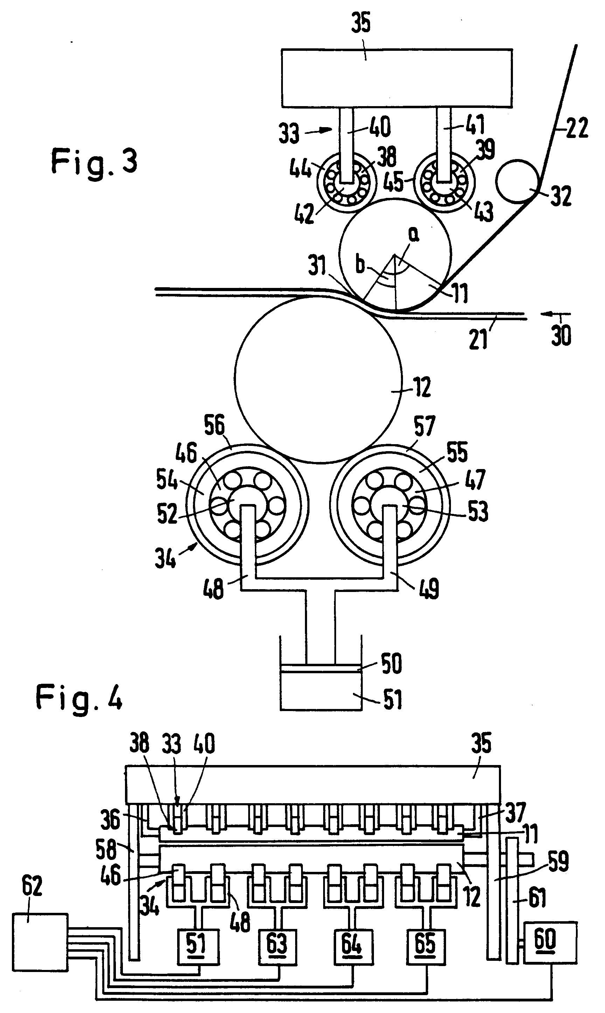

Fig. 2 zeigt einen stark vergrößerten Ausschnitt einer Schnittansicht von Bildträger 21 und Farbträger 22. Die Oberflächen von Bildträger 21 und Farbträger 22 sind nicht glatt. Vielmehr weisen sie eine im Vergleich zur Farbschicht 10 vergleichsweise große lokale Rauhigkeit auf. Die Rauhigkeit oder Rauhtiefe ist ein Maß für den Höhenunterschied d zwischen benachbarten "Gipfeln" 17 und "Tälern" 18. In gleicher Weise wird die Oberflächenrauhigkeit des Bildträgers 21 durch den Höhenunterschied p zwischen benachbarten Gipfeln und Tälern bestimmt. Es ist leicht einzusehen, daß in einem Bereich 19, in dem sich zwei Täler von Bildträger 21 und Farbträger 22 gegenüberstehen, ein geringerer Druck aufbaut als in einem Bereich 20, wo sich zwei Gipfel von Farbträger 22 und Bildträger 21 gegenüberstehen. Während im Bereich 20 die Farbübertragung zufriedenstellend sein wird, ist es möglich, daß im Bereich 19 aufgrund des geringeren Drucks eine Übertragung mit verminderter Qualität erzielt wird oder aufgrund eines fehlenden Kontakts gar keine Übertragung erfolgt.

Beim Durchlaufen des Walzenspalts zwischen den Walzen 11 und 12 wird nun ein so hoher Druck auf die zusammengefügten Schichten von Farbträger und Bildträger ausgeübt, daß sich die Oberflächenstrukturen von Farbträger und Bildträger einander angleichen. Dabei wird mindestens eine Oberfläche, möglicherweise auch beide, nachgeben und sich der anderen anpassen. Bei dieser Anpassung werden beide Träger 21, 22 an der Oberfläche eingedrückt und zwar um die Summe der Rauhtiefen, d.h. um den Betrag d + p. Dabei kann die eine Oberfläche fast die vollständige Eindrucktiefe aufnehmen, die andere hingegen fast gar nichts. Das Maß, wie sich die Eindrücke verteilen, ist nicht unbedingt von der vorherigen Rauhigkeit abhängig.

In Fig. 3 und 4 ist eine Vorrichtung zur Aufbringung des Drucks dargestellt. Der Bildträger 21 wird in Richtung des Pfeiles 30 (Einlaufrichtung) in den zwischen den Walzen 11 und 12 gebildeten Walzenspalt 31 geführt. Der Farbträger 22 wird über eine Umlenkrolle 32 zur Walze 11 geführt. Da der Farbträger 22 um die Walze 11 einen größeren Umschlingungswinkel a hat als der Bildträger 21 mit seinem Umschlingungswinkel b um die gleiche Walze 11, kommen Farbträger 22 und Bildträger 21 erst kurz vor dem Walzenspalt miteinander in Kontakt. Dadurch wird verhindert, daß durch kleine Reibbewegungen, die beispielsweise durch die Vibrationen der Vorrichtung hervorgerufen werden können, oder durch vorzeitiges Berühren mit den klebrigen Bereichen des Bildträgers Falten erzeugt sowie Farbe vom Farbträger abgenommen werden kann, die dann dort fehlt, wo sie eigentlich auf die dafür vorgesehenen Bereiche des Bildträgers aufgetragen werden sollte.

Um zu verhindern, daß sich die beiden Walzen unter dem im Walzenspalt 31 aufgebauten Druck durchbiegen und die Druckverteilung im Walzenspalt 31 ungünstig beeinflussen, sind die beiden Walzen 11, 12 über ihre Länge mit Hilfe von Abstützeinrichtungen 33, 34 abgestützt. Die Abstützeinrichtung 33 für die obere Walze 11 ist dabei starr an einem Träger 35 befestigt, der auch Lagerarme 36, 37 für die Walze 11 trägt. Die Abstützeinrichtung 33 besteht beispielsweise aus einer Reihe von in Längserstreckung der Walze 11 parallel zueinander angeordneten Kugellagern 38, 39, deren Innenringe 42, 43 mit Hilfe von Stützen 40, 41 am Träger 35 befestigt sind. Ihre Außenringe 44, 45 rollen auf der Oberfläche der Walze 11 ab. Die beiden Kugellager 38, 39 sind auf beiden Seiten einer Ebene angeordnet, die durch die Mittelachse der Walze 11 senkrecht zur Einlaufrichtung 30 verläuft. Dadurch ist die Abstützeinrichtung 33 nicht nur in der Lage, Kräfte senkrecht zur Einlaufrichtung aufzunehmen, sondern auch Kräfte parallel dazu. Natürlich können auch andere Wälzlager oder Gleitlager verwendet werden.

Die Abstützeinrichtung 34 weist auf beiden Seiten einer Ebene, die durch die Mittelachse der Walze 12 senkrecht zur Einlaufrichtung 30 verläuft, jeweils beispielsweise ein Kugellager 46, 47 auf, das über Stützen 48, 49 jeweils mit einem Kolben 50 von pneumatischen oder hydraulischen Druckerzeugungseinrichtungen 51, 63, 64, 65 verbunden ist. Dabei sind die Innenringe 52, 53 direkt an den Stützen 48, 49 befestigt, während die Außenringe der Kugellager 46, 47 von einer Zwischenlage 56, 57 umgeben sein können, die dann auf der Oberfläche der Walze 12 abrollen. Die Walze 12 ist in Lagerböcken 58, 59 gelagert, wobei sie in Wirkrichtung der Druckerzeugungseinrichtungen 51, 63, 64, 65 bewegbar ist, und wird von einem Motor 60 über eine geeignete Übertragungseinrichtung 61, beispielsweise einen Treibriemen, angetrieben. Die Lagerböcke 58, 59 tragen auch den Träger 35. Der von den Druckerzeugungseinrichtungen erzeugte Druck wirkt also von oben und unten auf den Spalt 31. Die Drehgeschwindigkeit des Motors 60 und die Druckerzeugung durch die Druckerzeugungseinrichtungen 51, 63, 64, 65 werden durch die Steuereinrichtung 62 gesteuert. Dabei wird in der Regel durch die mittleren Druckerzeugungseinrichtungen 63, 64 ein höherer Druck erzeugt, als durch die äußeren Druckerzeugungseinrichtungen 51, 65, um über die gesamte Breite des Walzenspaltes eine gleichmäßige Druckverteilung zu gewährleisten. Die Abstützeinrichtungen 33, 34 sind auf den Walzen jeweils selbstzentrierend.

Wie insbesondere aus Fig. 3 ersichtlich, haben die beiden Walzen 11, 12 unterschiedliche Durchmesser. Die mit dem Farbträger 22 in Berührung kommende Walze 11 hat dabei einen geringeren Durchmesser als die mit dem Bildträger 21 in Berührung kommende Walze 12. Je kleiner die Walze 11 ist, desto größer ist der mit gleicher Kraft erzeugbare Druck im Walzenspalt. Übliche Maße für die Durchmesser der kleineren Walze 11 liegen im Bereich zwischen 10 und 100 mm, bevorzugterweise bei 30 mm. Typische Durchmesserwerte für die größere Walze liegen in einem Bereich größer als 20 mm, bevorzugterweise bei etwa 70 mm. Im Extremfall kann die untere Walze 12 auch durch eine ebene Platte ersetzt werden.In diesem Fall handelt es sich um eine Walze mit dem Durchmesser unendlich. Der Versatz der beiden Walzenachsen in Einlaufrichtung bewegt sich in einem Bereich zwischen etwa 0,1 und 5 mm. Der Versatz vermindert ganz wesentlich die Gefahr einer Faltenbildung beim Durchlauf von Farbträger und Bildträger.

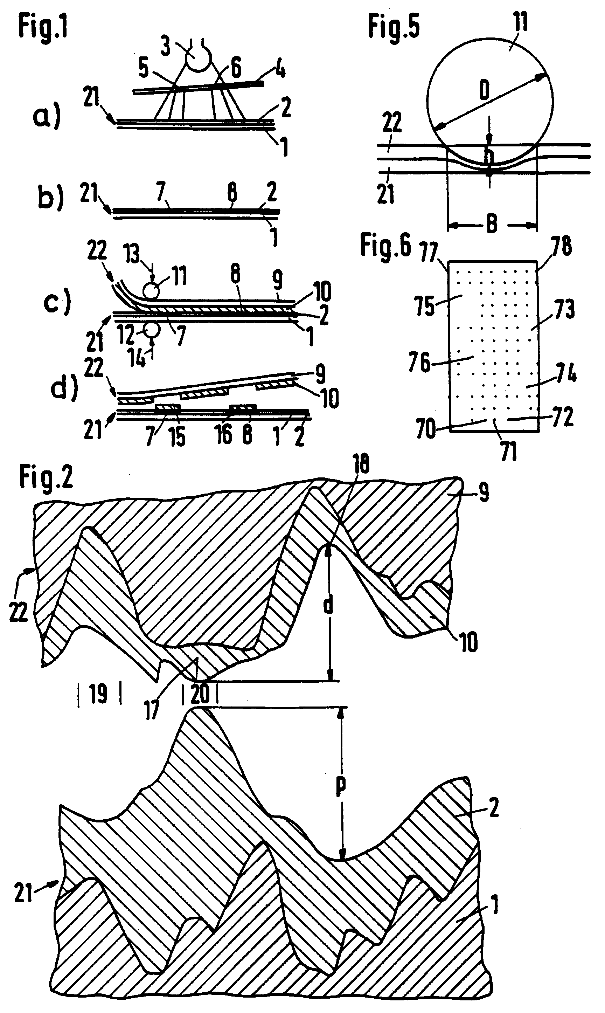

Fig. 5 zeigt schematisch ein Verfahren zur Ermittlung der Eindrucktiefe h. Die Tiefe h ist dabei übertrieben groß dargestellt. Die Walze 11 mit dem Durchmesser D wird dabei über die Druckerzeugungseinrichtungen 51, 63 - 65 mit Druck beaufschlagt, wobei allerdings kein Transport von Bildträger 21 und Farbträger 22 durch den Walzenspalt erfolgt. Der Bildträger 21 wurde zuvor so vorbereitet, daß ein regelmäßiges Raster von klebrigen 2 % Punkten an seiner Oberfläche entsteht. Bei dem Raster sind 60 Linien/cm vorgesehen, wobei die einzelnen Punkte einen Durchmesser von 27 μm haben. Wenn der Druck ausreichend groß war, entstehen in der Mitte mindestens eine, vorzugsweise drei Reihen 70 - 72, in denen alle Punkte zufriedenstellend mit Farbe versorgt sind. Es treten also keine Fehlstellen auf, an denen keine Farbübertragung stattgefunden hat. Je weiter man nach außen geht, desto ungleichmäßiger wird die Farbübertragung, d.h. die Fehlstellen 73 - 76 häufen sich. Dies zeigt schematisch Fig. 6. Außerhalb von zwei Punktreihen 77, 78 hat überhaupt keine Farbübertragung stattgefunden, d.h. in diesem Bereich wurden Bildträger 21 und Farbträger 22 gar nicht unter Druck aneinandergepreßt. Aus der Breite B, d.h. dem Abstand zwischen den beiden Punktreihen 77, 78 und dem Durchmesser D der Walze 11 läßt sich die Höhe h nach folgender Formel bestimmen

$$h = ( D - \sqrt{D^2 - B^2} ) / 2$$

Bei einem Versuch, bei dem als Unterlage 1 des Bildträgers 21 ein NW-Papier der Papierfabrik Schoeller verwendet wurde, auf das ein Cromalin C4/CP8Bx der Anmelderin auflaminiert wurde und der mit einem Farbträger nach DE 37 06 528 A (Beispiel 1d) in Kontakt gebracht wurde, ergab sich ein Abstand B von 2,4 mm zwischen den beiden Punktreihen 77 und 78. Der Durchmesser D der Walze 11 betrug 30 mm, der Durchmesser der anderen Walze 12 betrug 70 mm. Daraus errechnet sich eine Eindrucktiefe von 50 μm.

**Patentansprüche**

1. Schichtübertragungsverfahren zur Bilderzeugung, bei dem vorbestimmte Bereiche der Oberfläche eines Bildträgers zur Aufnahme einer Farbschicht vorbereitet werden, der Bildträger und ein Farbträger aus Schichtübertragungsmaterial unter Druck miteinander in Kontakt gebracht werden und der Farbträger vom Bildträger entfernt wird, wobei Farbe auf den vorbestimmten Bereichen des Bildträgers verbleibt, dadurch gekennzeichnet, daß der Kontakt unter so hohem Druck erfolgt, daß Bildträger (21) und/oder Farbträger (22) an ihren einander zugewandten Oberflächen zumindest temporär eingedrückt werden, wobei die Summe der Eindrucktiefen mindestens der Summe der lokalen Rauhtiefen (d, p) entspricht.

2. Verfahren nach Anspruch 1, dadurch gekennzeichnet, daß der Bildträger (21) an der dem Farbträger (22) zugewandten Oberfläche mindestens um die Summe der Rauhtiefen von Farbträger (22) und Bildträger (21) eingedrückt wird.

3. Verfahren nach Anspruch 1 oder 2, dadurch gekennzeichnet, daß bei einem eine Unterlage (1) aufweisenden Bildträger (21) die Größe des Drucks so begrenzt ist, daß die Unterlage (1) nur elastisch verformt wird.

4. Verfahren nach einem der Ansprüche 1 bis 3, dadurch gekennzeichnet, daß der Druck in einem kontinuierlich über Farb- und Bildträger (22, 21) parallel verschobenen, im Vergleich zur Länge schmalen Streifen erzeugt wird.

5. Verfahren nach einem der Ansprüche 1 bis 4, dadurch gekennzeichnet, daß Bildträger (21) und Farbträger (22) unbeheizt miteinander in Kontakt gebracht werden.

6. Verfahren nach einem der Ansprüche 1 bis 5, dadurch gekennzeichnet, daß Bildträger (21) und Farbträger (22) erst unmittelbar vor Aufbau des Drucks miteinander in Kontakt gebracht werden.

7. Verfahren nach einem der Ansprüche 1 bis 6, dadurch gekennzeichnet, daß auf die Unterlage (1) des Bildträgers (21) zur Vorbereitung der Oberfläche eine fotobeeinflußbare Schicht (2) aufgebracht und der Bildträger (21) daraufhin durch eine Bilderzeugungseinrichtung (3, 4) belichtet wird.

8. Verfahren nach Anspruch 7, dadurch gekennzeichnet, daß die fotobeeinflußbare Schicht (2) auflaminiert wird.

9. Verfahren nach Anspruch 7 oder 8, dadurch gekennzeichnet, daß die Oberfläche des Bildträgers (21) durch die Belichtung in den belichteten Bereichen in ihrer Klebrigkeit verändert wird.

10. Verfahren nach einem der Ansprüche 7 bis 9, dadurch gekennzeichnet, daß die Oberfläche des Bildträgers (21) durch die Belichtung in den belichteten Bereichen fotopolymerisiert wird.

11. Verfahren nach einem der Ansprüche 1 bis 10, dadurch gekennzeichnet, daß es mit einer Vorrichtung mit mindestens einem durch zwei Walzen gebildeten Walzenspalt (31), der durch, zwei harte Walzen (11, 12) gebildet ist, durchgeführt wird.

12. Verfahren nach Anspruch 11, dadurch gekennzeichnet, daß die beiden Walzen (11, 12) verschiedene Durchmesser aufweisen.

13. Verfahren nach Anspruch 11 oder 12, dadurch gekennzeichnet, daß die beiden Walzen (11, 12) in Bezug auf die Einlaufrichtung (30) des Bildträgers (21) zueinander versetzt angeordnet sind.

14. Verfahren nach einem der Ansprüche 11 bis 13, dadurch gekennzeichnet, daß die mit dem Farbträger (22) in Berührung stehende Walze (11) einen kleineren Durchmesser als die mit dem Bildträger (21) in Berührung stehende Walze (12) aufweist.

15. Verfahren nach einem der Ansprüche 11 bis 14, dadurch gekennzeichnet, daß der Umschlingungswinkel (a) des Farbträgers (22) um die ihm zugeordnete Walze (11) größer als der Umschlingungswinkel (b) des Bildträgers (21) um die gleiche Walze (11) ist.

16. Verfahren nach einem der Ansprüche 11 bis 15, dadurch gekennzeichnet, daß beide Walzen (11, 12) über ihre Länge senkrecht zur Einlaufrichtung (30) durch je eine Abstützeinrichtung (33, 34) abgestützt sind, wobei mindestens eine Abstützeinrichtung (34) insbesondere pneumatisch mit Druck beaufschlagbar ist.

17. Verfahren nach Anspruch 16, dadurch gekennzeichnet, daß jede Abstützeinrichtung (33, 34) Lagerelemente (38, 39; 46, 47) aufweist, die an der Oberfläche der zugeordneten Walze (11, 12) angreifen.

18. Verfahren nach Anspruch 17, dadurch gekennzeichnet, daß die Lagerelemente (38, 39, 46, 47) als Wälzlager, insbesondere als Kugellager, ausgebildet sind, deren Außenringe (44, 45; 54, 55) gegebenenfalls unter Zwischenlage eines Zwischenrings (56, 57) auf der Walzenoberfläche abrollen.

19. Verfahren nach einem der Ansprüche 16 bis 18, dadurch gekennzeichnet, daß jede Abstützeinrichtung (33, 34) Kräfte im wesentlichen parallel zur Einlaufrichtung (30) aufnimmt.

20. Verfahren nach einem der Ansprüche 16 bis 19, dadurch gekennzeichnet, daß die Abstützeinrichtungen (33, 34) auf den Walzen (11, 12) selbstzentrierend ausgebildet sind.

21. Verfahren nach Anspruch 19 oder 20, dadurch gekennzeichnet, daß die Lagerelemente (38, 39; 46, 47) auf beiden Seiten eine senkrecht zur Einlaufrichtung (30) durch die Walzenachse verlaufenden Ebene an der Walzenoberfläche angreifen.

**Claims**

1. Layer transfer process for image production, wherein predetermined areas of the surface of an image carrier are prepared to receive a colour layer, the image carrier and a colour carrier consisting of layer transfer material are brought into contact with one another under pressure and the colour carrier is removed from the image carrier, whereby colour remains on the predetermined areas of the image carrier, characterised in that the contact takes place under such high pressure that the image carrier (21) and/or colour carrier (22) are at least temporarily indented on their surfaces facing each other, the sum of the indentation depths corresponding to at least the sum of the local peak-to-valley heights (d, p).

2. Process according to claim 1, characterised in that the image carrier (21) is indented, on the surface facing the colour carrier (22), by at least the sum of the peak-to-valley heights of the colour carrier (22) and image carrier (21).

3. Process according to claim 1 or 2, characterised in that, with an image carrier (21) having a substrate (1), the magnitude of the pressure is limited so that the substrate (1) is only elastically deformed.

4. Process according to one of claims 1 to 3, characterised in that the pressure is generated in a strip, which is narrow in relation to its length, moving parallel and continuously over the colour and image carriers (22, 21).

5. Process according to one of claims 1 to 4, characterised in that the image carrier (21) and colour carrier (22) are brought into contact with one another without being heated.

6. Process according to one of claims 1 to 5, characterised in that the image carrier (21) and colour carrier (22) are not brought into contact with one another until immediately before the pressure is built up.

7. Process according to one of claims 1 to 6, characterised in that a photo-activatable layer (2) is applied to the substrate (1) of the image carrier (21) in order to prepare the surface and the image carrier (21) is then illuminated by an image production device (3, 4).

8. Process according to claim 7, characterised in that the photo-activatable layer (2) is laminated on.

9. Process according to claim 7 or 8, characterised in that the surface of the image carrier (21) is altered in its tackiness by the illumination in the illuminated areas.

10. Process according to one of claims 7 to 9, characterised in that the surface of the image carrier (21) is photopolymerised by the illumination in the illuminated areas.

11. Process according to one of claims 1 to 10, characterised in that it is carried out with an apparatus having at least one nip (31) formed by two rollers, which is formed by two hard rollers (11, 12).

12. Process according to claim 11, characterised in that the two rollers (11, 12) have different diameters.

13. Process according to claim 11 or 12, characterised in that the two rollers (11, 12) are offset relative to one another in relation to the direction of entry (30) of the image carrier (21).

14. Process according to one of claims 11 to 13, characterised in that the roller in contact with the colour carrier (22) has a smaller diameter than the roller (12) in contact with the image carrier (21).

15. Process according to one of claims 11 to 14, characterised in that the angle of looping (a) of the colour carrier (22) around the roller (11) associated therewith is greater than the angle of looping (b) of the image carrier (21) around the same roller (11).

16. Process according to one of claims 11 to 15, characterised in that the two rollers (11, 12) are each supported over their length, at right angles to the direction of entry (30), by a supporting device (33, 34), at least one supporting device (34) being adapted to be acted upon in, particular, by pneumatic pressure.

17. Process according to claim 16, characterised in that each supporting device (33, 34) has mounting elements (38, 39; 46, 47) which act on the surface of the associated roller (11, 12).

18. Process according to claim 17, characterised in that the mounting elements (38, 39, 46, 47) are constructed as roller bearings, more particularly ball bearings, the outer rings (44, 45; 54, 55) of which may roll over the surface of the roller, optionally via an intercalated intermediate ring (56, 57).

19. Process according to one of claims 16 to 18, characterised in that each supporting device (33, 34) absorbs forces substantially parallel to the direction of entry (30).

20. Process according to one of claims 16 to 19, characterised in that the supporting devices (33, 34) are constructed to be self-centring on the rollers (11, 12).

21. Process according to claim 19 or 20, characterised in that the mounting elements (38, 39, 46, 47) on both sides act on a plane on the roller surface, extending perpendicularly to the direction of entry (30) through the roller axis.

**Revendications**

1. Procédé de transfert de couches pour la production d'images, dans lequel des zones prédéterminées de la surface d'un support d'image sont préparées pour la réception d'une couche de couleur, le support d'image et un support de couleur en matériau de transfert de couches sont mis en contact l'un avec l'autre sous pression et le support de couleur est écarté du support d'image, de la couleur restant sur les zones prédéterminées du support d'image, caractérisé en ce que le contact s'effectue sous une pression si élevée que le support d'image (21) et/ou le support de couleur (22) sont, au moins temporairement, pressés l'un contre l'autre par leurs surfaces tournées l'une vers l'autre, la somme des profondeurs d'empreinte correspondant au moins à la somme des profondeurs d'aspérité des surfaces locales (d, p).

2. Procédé suivant la revendication 1, caractérisé en ce que le support d'image (21) est pressé par sa surface tournée vers le support de couleur (22) au moins de la somme des profondeurs d'aspérité des surfaces du support de couleur (22) et du support d'image (21).

3. Procédé suivant la revendication 1 ou 2, caractérisé en ce que, dans le cas d'un support d'image (21) présentant une base (1), la valeur de la pression est limitée de manière telle que la base (1) ne soit déformée que de manière élastique.

4. Procédé suivant l'une quelconque des revendications 1 à 3, caractérisé en ce que la pression est produite dans une bande étroite en comparaison avec sa longueur continuellement déplacée parallèlement au support d'image et au support de couleur (22, 21).

5. Procédé suivant l'une quelconque des revendications 1 à 4, caractérisé en ce que le support d'image (21) et le support de couleur (22) sont mis en contact l'un avec l'autre sans être chauffés.

6. Procédé suivant l'une quelconque des revendications 1 à 5, caractérisé en ce que le support d'image (21) et le support de couleur (22) ne sont mis en contact l'un avec l'autre que directement avant l'établissement de la pression.

7. Procédé suivant l'une quelconque des revendications 1 à 6, caractérisé en ce qu'une couche photoinfluençable (2) est appliquée sur la base (1) du support d'image (21) pour préparer la surface et le support d'image (21) est ensuite exposé par un dispositif de production d'images (3,4).

8. Procédé suivant la revendication 7, caractérisé en ce que la couche photoinfluençable (2) est appliquée par laminage.

9. Procédé suivant la revendication 7 ou 8, caractérisé en ce que la surface du support d'image (21) est modifiée dans son caractère adhésif par l'exposition dans les zones exposées.

10. Procédé suivant l'une quelconque des revendications 7 à 9, caractérisé en ce que la surface du support d'image (21) est photopolymérisée par l'exposition dans les zones exposées.

11. Procédé suivant l'une quelconque des revendications 1 à 10, caractérisé en ce qu'il est exécuté avec un dispositif présentant au moins un intervalle (31) formé entre deux cylindres, cet intervalle étant formé entre deux cylindres durs (11,12).

12. Procédé suivant la revendication 11, caractérisé en ce que les deux cylindres (11, 12) présentent des diamètres différents.

13. Procédé suivant la revendication 11 ou 12, caractérisé en ce que les deux cylindres (11, 12) sont disposés en décalage l'un par rapport à l'autre avec référence à la direction d'entrée (30) du support d'image (21).

14. Procédé suivant l'une quelconque des revendications 11 à 13, caractérisé en ce que le cylindre (11) se trouvant en contact avec le support de couleur (22) présente un diamètre inférieur à celui du cylindre (12) se trouvant en contact avec le support d'image (21).

15. Procédé suivant l'une quelconque des revendications 11 à 14, caractérisé en ce que l'angle d'enroulement (a) du support de couleur (22) autour du cylindre (11) qui y est associé, est supérieur à l'angle d'enroulement (b) du support d'image (21) autour du même cylindre (11).

16. Procédé suivant l'une quelconque des revendications 11 à 15, caractérisé en ce que les deux cylindres (11, 12) sont supportés sur leur longueur chacun perpendiculairement par rapport à la direction d'entrée, par un dispositif d'appui (33,34), au moins un dispositif d'appui pouvant être sollicité par pression, en particulier par pression pneumatique.

17. Procédé suivant la revendication 16, caractérisé en ce que chaque dispositif d'appui (33, 34) comporte des éléments à roulement (38, 39; 46, 47) qui agissent sur la surface du cylindre associé (11, 12).

18. Procédé suivant la revendication 17, caractérisé en ce que les éléments à roulement (38, 39, 46, 47) ont la forme de roulements en particulier de roulements à billes, dont les bagues extérieures (44, 45; 54, 55) roulent le cas échéant avec intercalation d'une bague intermédiaire (56, 57) sur la surface des cylindres.

19. Procédé suivant l'une quelconque des revendications 16 à 18, caractérisé en ce que chaque dispositif d'appui (33, 34) supporte des efforts essentiellement parallèles à la direction d'entrée (30).

**20.** Procédé suivant l'une quelconque des revendications 16 à 19, caractérisé en ce que les dispositifs d'appui (33 ,34) sont conçus de manière à se centrer automatiquement sur les cylindres (11, 12).

**21.** Procédé suivant la revendication 19 ou 20, caractérisé en ce que les éléments à roulement (38, 39; 46, 47) attaquent la surface des cylindres de part et d'autre d'un plan perpendiculaire à la direction d'entrée (30) et passant par l'axe des cylindres.

Fig. 3

Fig. 4

**Fig.1**

a)

b)

c)

d)

**Fig.5**

**Fig.6**

**Fig.2**